Europäisches Patentamt

European Patent Office

Office européen des brevets

(19)

(11) EP 0 471 243 B1

(12) **EUROPÄISCHE PATENTSCHRIFT**

(45) Veröffentlichungstag und Bekanntmachung des Hinweises auf die Patenterteilung:
**22.01.1997 Patentblatt 1997/04**

(51) Int Cl.6: **H01L 29/94**, H01L 21/334

(21) Anmeldenummer: **91112929.4**

(22) Anmeldetag: **01.08.1991**

(54) **Verfahren zur Herstellung einer Kondensatoranordnung mit grosser Kapazität**

Manufacturing method for capacitor device with large capacity

Procédé de fabrication d'un dispositif à condensateur à grande capacité

(84) Benannte Vertragsstaaten:
**AT CH DE FR GB IT LI NL**

(30) Priorität: **14.08.1990 DD 343430**

(43) Veröffentlichungstag der Anmeldung:
**19.02.1992 Patentblatt 1992/08**

(73) Patentinhaber: **INSTITUT FUR HALBLEITERPHYSIK**
**D-15230 Frankfurt (DE)**

(72) Erfinder: **Temmler, Dietmar, Dr.-Ing.**
**O-1200 Frankfurt (Oder) (DE)**

(74) Vertreter: **Bomberg, Siegmar**
**Berliner Strasse 41**
**15230 Frankfurt (DE)**

(56) Entgegenhaltungen:
**GB-A- 2 197 534**

- **IBM TECHNICAL DISCLOSURE BULLETIN Band 30, Nr. 7, Dezember 1987, Seiten 462-464, Armonk, NY, US; "Multi-Plate Storage Capacitor for Dram"**
- **IBM TECHNICAL DISCLOSURE BULLETIN Band 33, Nr. 5, Okfober 1990, Seiten 473-474, Armonk, NY, US; "Multi-Shell Trench Capacitor Cell for Quarter Giga Bit Dram and Beyond"**

## Beschreibung

Die Erfindung betrifft ein Verfahren zur Herstellung einer Kondensatoranordnung mit großer Kapazität für integrierte mikroelektronische Schaltungsanordnungen in Bipolar-, MOS- oder BICMOS-Schaltungstechnik vorzugsweise in Silizium-Technologie beziehungsweise für diskrete Chipkondensatoren oder auch passiven Kapazitätsnetzwerken.

Kondensatoranordnungen als integrierte Kapazitäten werden bekanntermaßen in integrierten Schaltungsanordnungen der Nachrichten- und Informationstechnik, insbesondere in MOS-Analog-Schaltungsanordnungen, beispielsweise für A/D- und D/A-Wandler und Filterschaltkreise, und darüber hinaus in weiteren bekannten Anwendungsfällen als Stütz- und Speicherkapazitäten eingesetzt (vgl. Wissenschaftliche Zeitschrift der TU Dresden, 34/1985/4, S. 131 - 138; Proc. IEEE, vol. 71/1983/8, S. 967 - 986; IEEE J. of solid state circuits, 1989/1, S. 165 - 173).

Es ist bekannt, diese integrierten Kapazitäten entweder als MOS-Kapazität, bestehend aus einer hochdotierten Polysilizium-Elektrode auf einem über einem hochdotierten Siliziumsubstratgebiet befindlichen dünnen thermischen Oxid, oder als Polysilizium 1-Polysilizium 2-Kapazität, bestehend aus einer auf einem dicken Feldisolator angeordneten hochdotierten Polysilizium 1-Elektrode und einer darüber auf einem, die Polysilizium 1-Elektrode bedeckenden thermischen und/oder CVD-Isolator (Dielektrikum) befindlichen hochdotierten Polysilizium 2-Elektrode, auszuführen. Dabei werden zur Herstellung die bekannten Konstruktions- und Verfahrenselemente der jeweiligen MOS-Technologie eingesetzt. Derartige Kondensatoranordnungen erfüllen mit ihren Parametern hohe applikative Anforderungen (siehe Tabelle).

Tabelle

| Parameter | Wertebereich |
|---|---|
| absolute C-Toleranz, bezogen auf einen Sollwert $C_0$ | $\frac{C - C_0}{C_0} = 10 \ldots 20 \%$ |
| D-Differenz-Toleranz, eng benachbarter, gleicher C | $\frac{C}{C}$ 0,1 ... 0,01 % |
| Temperaturkoeffizient | $T_{CC} = \frac{dC}{C \cdot dT}$ 10 ... 50 ppm/°K |
| Spannungskoeffizient | $V_{CC} = \frac{dC}{C \cdot dV}$ 20 ... 200 ppm/V |
| parasitäre Kapazität zum Substrat | $C_P/C$ 5 ... 30 % |

Nachteil dieser als integrierte Kapazität eingesetzten Kondensatoranordnungen ist, daß nur eine niedrige Kapazitätsflächendichte von $\leq 3$ nF/mm$^2$ (bei 10 nm SiO$_2$-äquivalenter Isolatordicke) realisierbar ist. Dadurch wird die absolute Größe der integrierten Kapazität flächenbedingt ($\leq 10$ mm$^2$) auf < 30 nF begrenzt. Um höhere Kapazitätswerte zu ermöglichen, ist es bekannt, die integrierte Schaltungsanordnung extern (off-chip) mit diskreten Kondensatoranordnungen konventioneller Bauformen auf dem Niveau der Leiterkarte bzw. des Hybridchips zu beschalten. Durch dabei auftretende leitungsbedingte Signallaufzeiten, parasitäre Induktivitäten sowie Störeinkopplungen durch externe Kapazitäten und Hybridverdrahtung werden die Qualität und Zuverlässigkeit negativ beeinflußt. Es sind eine Vielzahl diskreter Kondensatoranordnungen (Kondensatoren) bekannt, die eine für die Packungsdichte elektronischer Baugruppen auf dem Niveau der Leiterkarte (printed circuit board) bzw. Hybridchips montagegünstige Bauform und eine entsprechende spezifische Volumenkapazität (in F/cm$^3$), die den spezifischen Platzbedarf des Kondensators auf der Leiterkarte bzw. Hybridchip bestimmt, neben den Hauptparametern Kapazität und Einsatzspannung aufweisen. So sind Doppelschicht- und Elektrolytkondensatoren bekannt, die eine ausreichend hohe spezifische Volumenkapazität ermöglichen, die es gestattet, entsprechend dem Anforderungsniveau moderner elektronischer Geräte und Baugruppen auch große Kapazitäten im nF-Bereich zu realisieren (vgl. Taschenbuch Elektrotechnik, Band 3/1, S. 243 - 271, Verlag Technik Berlin, 1989).

Nachteilig sind jedoch der hohe Verlustfaktor, die Polaritätsabhängigkeit (spannungsunsymmetrische Charakteristik), das hohe Reststromniveau und die große parasitäre Induktivität (insbesondere bei den als Wickelkörper ausgeführten Bauformen).

Im Unterschied dazu sind Anordnungen und Verfahren zur Herstellung integrierter Kapazitäten in Form von Trenchkapazitäten für Hochintegrierte dynamische speicherzellen (dRAM) bekannt, bei denen die große spezifische Flächenkapazität durch Vergrößerung der inneren Oberfläche des Trenches mittels geätzter Siliciumlamellen erreicht wird (IBM Technical Disclosure Bulletin, **30** (1987)m No. 7, 462 - 464; GB -A-2197534).

Ziel der Erfindung ist ein Verfahren zur Herstellung einer Kondensatoranordnung, die als integrierte Kapazität in einer integrierten mikroelektronischen Schaltungsanordnung einen Kapazitätswertebereich von 10 nF ... 20 µF mit Parametern, die hohen applikativen Anforderungen entsprechen, und hohe Qualität und Zuverlässigkeit ermöglicht sowie als diskreter Chipkondensator einen geringen Verlustfaktor und ein niedriges Reststromniveau gewährleistet und das Auftreten einer parasitären Induktivität vermeidet.

Der Erfindung liegt die Aufgabe zugrunde, ein Verfahren zur Herstellung einer einer Kondensatoranordnung zu schaffen, die als integrierte Kapazität in einer integrierten mikroelektronischen Schaltungsanordnung eine Kapazitätsflächendichte von 10 ... 150 nF/mm$^2$ (bei 10 nm SiO$_2$-äquivalenter Isolatordicke) bei Vermeidung leitungsbedingter Signallaufzeiten, parasitärer Induktivitäten und Störeinkopplungen gewährleistet und die als diskreter Chipkondensator eine sehr hohe spezifische Volumenkapazität ermöglicht.

Das erfindungsgemäße Verfahren zur Herstellung dieser Kondensatoranordnung mit großer Kapazität ist durch die Merkmale von Anspruch 1 gekennzeichnet, und umfaßt, daß auf ein Halbleitersubstrat 1, vorzugsweise aus Silizium, eine Hilfsschicht 2 aufgebracht, mit einer Reliefmaske 3 bedeckt und steilflankig strukturiert wird, daß nach Entfernung der Reliefmaske 3 beginnend und endend mit einer Abscheidung einer Lamellenschicht 4 in abwechselnder Folge eine Lamellenschicht 4 und danach eine Opferschicht 5 abgeschieden werden und nach jeder Abscheidung einer Opferschicht 5 mit einem anisotropen RIE-Prozeß die parallel zur Substratoberfläche angeordneten Bereiche den Opferschicht 5 wieder entfernt werden, daß im Anschluß daran durch einen RIE-Prozeß der parallel zur Substratoberfläche angeordnete, aus den Lamellenschichten 4 bestehende Schichtstapel entfernt wird, daß nachfolgend mit einem isotropen, naßchemischen Ätzprozeß die dicke Hilfsschicht 2 sowie Opferschichtbereiche vollständig entfernt werden, daß im Anschluß daran ein die erzeugte Lamellenstruktur umgebendes Dielektrikum 9 erzeugt wird, daß danach eine Deckelektrode 10 abgeschieden wird und daß nach der Strukturierung der Deckelektrode 10 ein Kontaktierungsprozeß ausgeführt wird.

In einer ersten Ausgestaltung des erfindungsgemäßen Verfahrens wird als Lamellenschicht 4 Polysilizium und als Opferschicht Siliziumdioxid eingesetzt.

Das erfindungsgemäße Verfahren ist in einer weiteren Ausgestaltung dadurch gekennzeichnet, daß nach dem vollständigen Entfernen der Hilfsschicht 2 sowie der bestehenden Opferschichten mit einem das Lamellenschichtmaterial selektiv ätzenden, anisotropen RIE-Prozeß, die parallel zur Substratoberfläche liegenden Bereiche der Lamellenschichten 4 entfernt werden, daß anschließend mit einem selektiv ätzenden, anisotropen RIE-Prozeß, wobei die erzeugte Lamellenstruktur der Lamellenschichten als Ätzmaske dient, das Halbleitersubstrat 1 strukturiert wird und daß danach die als Ätzmaske dienende Struktur aus den Lamellenschichten 4 entfernt wird. Die Lamellenschichten bestehen hierbei vorzugsweise aus Siliziumnitrid und die Hilfsschichten 5 aus Siliziumdioxid.

In beiden Ausgestaltungen des erfindungsgemäßen Verfahrens erfolgt die Ausbildung der Deckelektrode 10 durch Abscheidung und Strukturierung einer dotierten Polysiliziumschicht und die Erzeugung des die Lamellenstruktur umgebenden Dielektrikums 9 durch Oxydation, Siliziumnitridabscheidung und Reoxidation.

Die erfindungsgemäße Kondensatorstruktur ist durch folgende Merkmale vorteilhaft gekennzeichnet:

- Erhöhung der Kapazitätsflächendichte gegenüber konventionell integrierten Kapazitäten um einen Faktor von 10 ... 50 (10 nF ... 150 nF/mm$^2$), damit ergibt sich ein Kapazitätswertebereich von ca. 10 nF ... 20 μF.

- Integrationsfähigkeit in alle modernen Halbleitertechnologien, wie BIPOLAR-, CMOS- und BICMOS-Technik.

- Qualitäts- und Zuverlässigkeitserhöhung durch Vermeidung leitungsbedingter Signallaufzeiten, parasitärer Induktivitäten, Störeinkopplung (Wegfall externer Kapazitäten und von Hybridverdrahtung) sowie durch Wegfall äußerer Kapazitäten, Leitungen und Kontaktstellen.

- Erhalt der bei konventionell erzeugten Kapazitäten auftretenden Parameter, die hohen applikativen Anforderungen gerecht werden.

Desweiteren ist bei der erfindungsgemäßen Kondensatoranordnung durch eine entsprechende Fuse-Programmierung der Abgleich auf einen definierten Kapazitäts-Absolutwert möglich.

Das erfindungsgemäße Verfahren zur Herstellung einer Kondensatoranordnung mit großer Kapazität für integrierte mikroelektronische Schaltungsanordnungen in Bipolar-, MOS- oder BICMOS-Schaltungstechnik beziehungsweise von diskreten Chipkondensatoren soll nachstehend anhand von zwei Ausführungsbeispielen näher erläutert werden.

In der dazugehörigen Zeichnung zeigen

Fig. 1       das Reliefmasken-Layout
Fig. 2a      den Querschnitt parallel zur Substratoberfläche (Schnitt C-D, Fig. 2b)
Fig. 2b      den Querschnitt senkrecht zur Substratoberfläche bei aus dem Halbleitersubstrat gebildeter Lamellenstruktur (Schnitt A-B, Fig. 2a)
Fig. 2c      den Querschnitt senkrecht zur Substratoberfläche bei aus Polysilizium gebildeter Lamellenstruktur (Schnitt A-B, Fig. 2a)
Fig. 3a-i    Verfahrensschrittfolge zur Erzeugung der Lamellenstruktur

Mit dem im ersten Ausführungsbeispiel beschriebenen Verfahren wird die Integration einer oder mehrerer Kapazitäten in einer integrierten mikroelektronischen Schaltungsanordnung ermöglicht, wobei die Kondensatorstruktur in das Halbleitersubstrat 1 hinein versenkt angeordnet ist, so daß die Deckelektrode 10 annähernd mit dem Niveau der Substratoberfläche abschließt und ein Oberflächenvergrößerungsfaktor gegenüber einer herkömmlichen planaren Kondensatoranordnung (integrierter Kapazität) von 20 ... 50 erreicht wird. Dabei ist die Erzeugung der Kondensatoranordnung vorzugsweise am Beginn des Herstellungszyklus der integrierten Schaltungsanordnung eingeordnet, wobei technologische Verfahrensschritte dieses Herstellungszyklus, wie dotierte Wannen und Feldisolation zur lateralen und vertikalen Isolation, Gateoxidation und die Abscheidung, Dotierung und Strukturierung von Polysilizium zur Erzeugung von Dielektrikum und Deckelektrode u. a. genutzt werden.

Mit dem im ersten Ausführungsbeispiel beschriebenen Verfahren wird desweiteren die Erzeugung von diskreten Chipkondensatoren mit Leiterkarten- oder hybridchipgerechter Bauform ohne Integration weiterer Elemente ermöglicht, wobei die Kondensatoranordnung vorzugsweise jeweils auf der Vorder- und Rückseite des eingesetzten Halbleitersubstrats 1 integriert wird. Dabei ist eine Versenkung der Kondensatorstruktur in das Halbleitersubstrat 1 ebenfalls möglich.

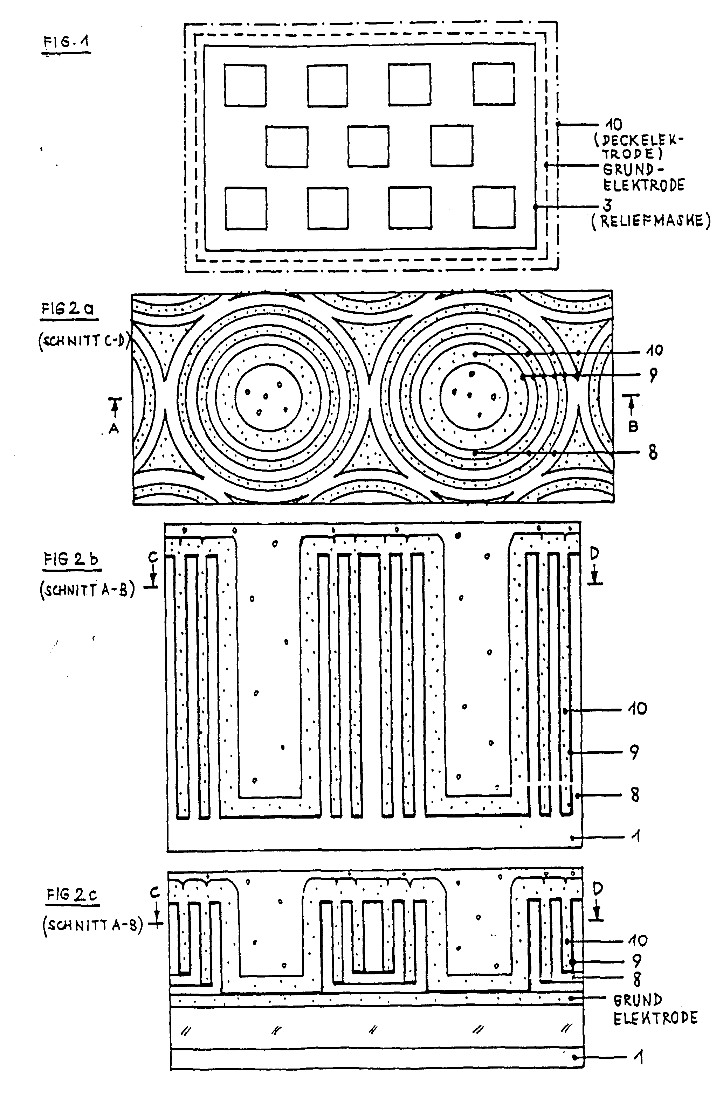

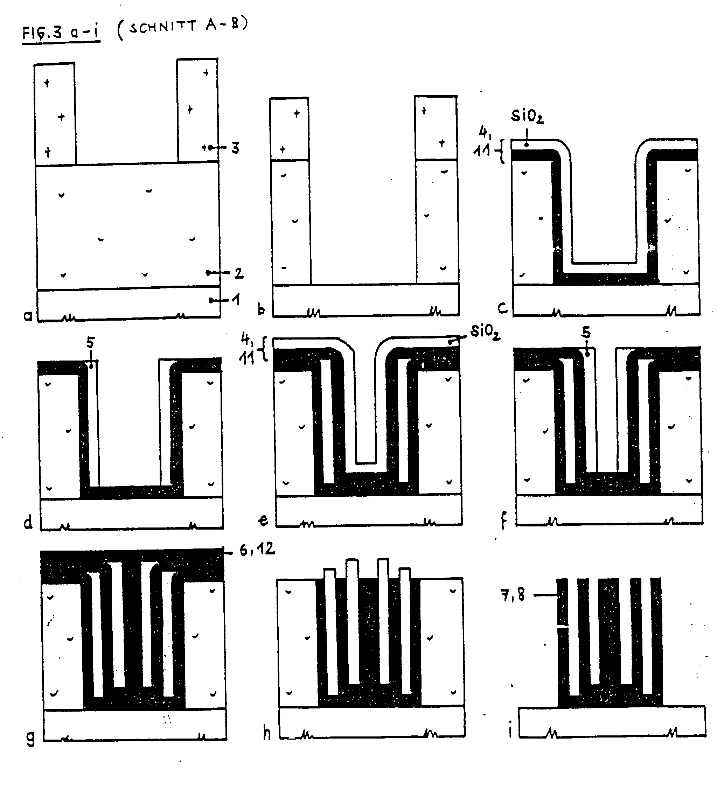

Zur Herstellung der Kondensatorstruktur wird nach dem ersten Ausführungsbeispiel zunächst nach Abscheidung einer ca. 1 µm dicken $SiO_2$-Schicht 2 auf die vorbereitete Oberfläche eines Si-Substrates 1 eine steilflankige Reliefmaske 3 (Fig. 1) aufgebracht (Fig. 3a) und die dicke $SiO_2$-Schicht 2 mit einem anisotropen RIE-Verfahren steilflankig strukturiert, wobei als Ätzstopp die Oberfläche des Si-Substrates 1 wirkt (Fig. 3b). Nach Entfernung der Reliefmaske 3 und einem Reinigungsschritt erfolgt die Abscheidung einer Doppelschicht aus 200 nm $Si_3N_4$ 4 und 200 nm $SiO_2$ 5 (Fig. 3c). Danach werden mit einem anisotropen RIE-Verfahren die parallel zur Si-Oberfläche angeordneten $SiO_2$-Schichtbereiche 5 wieder entfernt, wobei der RIE-Prozeß, bedingt durch seine Selektivität auf der $Si_3N_4$-Schicht 4 stoppt (Fig. 3d). Dadurch verbleiben an den mit $Si_3N_4$ bedeckten Steilflanken der Schichtstruktur vertikale $SiO_2$-Schichtabschnitte 5, deren Dicke ca. 200 nm beträgt, während an allen parallel zur Substratoberfläche angeordneten Abschnitten die $Si_3N_4$-Schicht 4 bloßgelegt wird und verglichen mit der ursprünglichen Abscheidedicke einen Abtrag aufweist. Nach einem Reinigungsprozeß wird eine weitere $Si_3N_4$/$SiO_2$-Doppelschicht abgeschieden (Fig. 3e) und ein weiteres gleichartiges, anisotropes RIE-Verfahren mit Ätzstopp auf der $Si_3N_4$-Schicht 4 ausgeführt (Fig. 3f), so daß nach diesem Schritt alle mit der zweiten $Si_3N_4$-Schicht 4 bedeckten Steilflanken der Schichtstruktur ebenfalls mit darüberliegenden $SiO_2$-Schichtabschnitten 5 von ca. 200 nm Dicke bedeckt sind. Danach wird eine abschließende $Si_3N_4$-Schichtabscheidung 4 von 200 nm ausgeführt (Fig. 3g) und anschließend eine planarisierende $Si_3N_4$-RIE-Ätzung, die den parallel zur Si-Substratoberfläche angeordneten $Si_3N_4$-Schichtstapel aus den aufeinander abgeschiedenen $Si_3N_4$-Schichten 4 entfernt, wobei das RIE-Verfahren durch ein Überätzmaß von ca. 100 nm die Oberkanten der an den Steilflanken der Struktur liegenden $SiO_2$-Schichtabschnitte 5 und die Oberfläche der 1 µm dicken $SiO_2$-Schicht 2 sicher freilegt (Fig. 3h). Durch die Selektivität des RIE-Verfahrens zum Si-Substrat 1 wird dieses dabei an den nur von der lateralen $Si_3N_4$-Dreifachschicht bedeckten Oberflächenbereichen nur wenig abgetragen. Danach wird mittels eines isotropen, naßchemischen Ätzverfahrens sowohl die 1 µm dicke $SiO_2$-Schicht 2 als auch die an den Steilflanken liegenden $SiO_2$-Schichten 5 selektiv zu den $Si_3N_4$-Schichten 4 restlos entfernt (Fig. 3i), so daß auf der Si-Substratoberfläche eine $Si_3N_4$-Lamellenstruktur 4 verbleibt, die z. T. über die nach den beiden $SiO_2$-RIE-Schritten verbliebenen lateralen $Si_3N_4$-Schichtreste in sich verbunden ist. Mit einem weiteren anisotropen $Si_3N_4$-RIE-Schritt werden diese lateralen $Si_3N_4$-Schichten entfernt, wobei sich gleichzeitig die Höhe der $Si_3N_4$-Lamellen 4 um den Ätzabtrag reduziert, jedoch aufgrund der Selektivität des RIE-Verfahrens das Si-Substrat 1 nur geringfügig abgetragen wird. Diese endgültige $Si_3N_4$-Lamellenstruktur wird anschließend mittels eines anisotropen Si-RIE-Verfahrens in das Si-Substrat übertragen, wobei die $Si_3N_4$-Maske entsprechend der Selektivität des RIE-Verfahrens zum Teil abgetragen wird. Die zu erreichende Ätztiefe beträgt dabei für einen Oberflächenvergrößerungsfaktor von $C/C_{PL}$ 30 ca. 4 µm, bei einer Rastergröße des Layouts (Fig. 1) von 2 µm. ($C/C_{PL}$ = Kapazität der Reliefoberfläche zu der der planaren Ausgangsfläche)

Nach anschließenden Prozeßschritten zur Entfernung der Reste der $Si_3N_4$-Maske, der Überätzung, Glättung, Dotierung und Reinigung der Si-Lamellenstruktur wird durch Oxidation, Nitridabscheidung und Reoxidation ein ONO-Speicherdielektrikum 9 von ca. 20 nm Dicke ($SiO_2$-Äquivalent) erzeugt und eine dotierte Polysiliziumschicht als Deckelektrode 10 so abgeschieden, daß sie die Lamellenzwischenräume vollständig ausfüllt. Abschließend erfolgt die Strukturierung dieser Deckelektrode 10 durch Lithografie und RIE-Ätzung und die Kontaktierung sowohl der Deckelektrode 10 als auch des dotierten Gebietes, in dem die dotierte, lamellierte Si-Grundelektrode angeordnet ist (Fig. 2a, 2b).

Mit dem im zweiten Ausführungsbeispiel beschriebenen Verfahren wird die Integration einer oder mehrerer Kapazitäten in einer integrierten mikroelektronischen Schaltungsanordnung ermöglicht, wobei die Kondensatorstruktur nicht in das Halbleitersubstrat hinein versenkt ist, ein Oberflächenvergrößerungsfaktor gegenüber einer herkömmlichen planaren Kondensatoranordnung (integrierten Kapazität) von 10 ... 20 erreicht wird und die technologischen Verfahrensschritte des Herstellungszyklus der integrierten Schaltungsanordnung weitgehend mit genutzt werden.

Das erfindungsgemäße Verfahren zur Herstellung der Kondensatoranordnung wird entweder ab beziehungsweise nach Erzeugung von Polysiliziumschichtebenen oder am Ende des Herstellungszyklus der integrierten Schaltungsanordnung, jedoch vor Aufbringen der Metallisierungsebenen, vorzugsweise vor der ersten Metallisierungsebene ($T_s >$

900 °C), eingeordnet. Die Grundelektrode der erfindungsgemäßen Kondensatorstruktur ist entweder an das Halbleitersubstrat 1 angeschlossen beziehungsweise von diesem durch einen PN-Übergang isoliert oder mit einer dotierten Polysiliziumschicht unterlegt, die vom Halbleitersubstrat 1 durch eine dielektrische Isolationsschicht isoliert ist.

Im zweiten Ausführungsbeispiel wird nach Abscheidung einer 1,1 µm dicken $SiO_2$-Schicht 2 auf ein vorbereitetes Si-Substrat 1 eine steilflankige Reliefmaske 3 (Fig. 1) aufgebracht (Fig. 3a). Anschließend wird die dicke $SiO_2$-Schicht 2 durch ein RIE-Verfahren strukturiert, wobei der Ätzstopp auf der Oberfläche des Si-Substrates 1 beziehungsweise auf der zur Kontaktierung aufgebrachten Polysiliziumschicht erfolgt (Fig. 3b).

Nach Entfernung der Reliefmaske 3 und einem Reinigungsschritt erfolgt die Abscheidung einer Doppelschicht aus dotiertem Polysilizium 4 (200 nm) und $SiO_2$ 5 (200 nm) (Fig. 3c). Danach werden die parallel zur Substratoberfläche angeordneten $SiO_2$-Schichtabschnitte mit einem anisotropen RIE-Verfahren wieder entfernt, wobei der RIE-Schritt selektivitätsbedingt auf der Polysiliziumschicht stoppt (Fig. 3d). Dadurch verbleiben an den mit Polysilizium bedeckten Steilflanken der Struktur vertikale $SiO_2$-Schichtabschnitte 5 von ca. 200 nm Dicke, während an allen parallel zur Substratoberfläche angeordneten polysiliziumbeschichteten Abschnitten die Polysiliziumschicht 4 bloßgelegt und durch das RIE-Verfahren nur wenig abgedünnt ist. Nach einem Reinigungsprozeß wird eine weitere Doppelschicht aus dotierte Polysilizium 4 (200 nm) und $SiO_2$ (200 nm) abgeschieden (Fig. 3e) und ein weiteres anisotropes RIE-Verfahren mit Ätzstopp auf der dotierten Polysiliziumschicht 4 ausgeführt, so daß danach alle mit der zweiten Polysiliziumschicht 4 bedeckten Steilflanken der Struktur mit vertikalen $SiO_2$-Schichtabschnitten 5 von ca. 200 nm Dicke bedeckt sind (Fig. 3f). Danach wird eine abschließende dotierte Polysiliziumschicht 12 von 200 nm Dicke abgeschieden (Fig. 3g) und anschließend eine planarisierende Polysilizium-RIE-Ätzung durchgeführt, die den parallel zur Si-Substratoberfläche angeordneten Polysiliziumschichtstapel aus den drei übereinanderliegenden Polysiliziumschichten 4 entfernt, wobei das RIE-Verfahren durch ein Überätzmaß von ca. 100 nm die Oberkanten der an den Steilflanken der Struktur liegenden $SiO_2$-Schichtabschnitte 5 und die Oberfläche der 1 µm dicken $SiO_2$-Schicht 2 sicher freilegt (Fig. 3h). Danach wird mittels eines isotropen naßchemischen Ätzverfahrens sowohl die freigelegte dicke $SiO_2$-Schicht 2 als auch die an den Steilflanken liegenden $SiO_2$-Schichten 5 restlos und mit hoher Selektivität entfernt, so daß auf der Siliziumsubstrat-Oberfläche eine dotierte polykristalline Silizium-Lamellenstruktur entsteht, die z. T. über laterale Polysilizium-Schichtbereiche verbunden sind (Fig. 3i).

Die Höhe der Lamellenstruktur über dem Si-Substratniveau hängt von der Dicke der dicken $SiO_2$-Schicht 2, dem Überätzmaß und der Selektivität des planarisierenden Polysilizium-RIE-Verfahrens zur Entfernung des lateralen Polysilizium-Dreifachschichtstapels ab. Für einen Oberflächenvergrößerungsfaktor $C/C_{PL}$ von 10 ist für eine Rastergröße des Layouts (Fig. 1) von 2 µm eine 1 µm hohe polykristalline Si-Lamellenstruktur notwendig.

Nach Prozeßschritten zur Glättung und Reinigung der Si-Lamellenstruktur wird durch Oxidation, Nitridabscheidung und Reoxidation ein ONO-Speicherdielektrikum 9 von 20 nm Dicke ($SiO_2$-Äquivalent) erzeugt und eine dotierte Polysiliziumschicht 10 von 350 nm abgeschieden, die die Lamellenzwischenräume vollständig ausfüllt. Abschließend erfolgt durch Lithografie und RIE die Strukturierung dieser Deckelektrode 10 und danach deren Kontaktierung sowie die Kontaktierung der Grundelektrode (Fig. 2a, 2c).

## Patentansprüche

1. Verfahren zur Herstellung einer Kondensatoranordnung mit großer spezifischer Flächenkapazität als on-chip-integriertes kapazitives Element in integrierten mikroelektronischen Schaltungen, vorzugsweise auf Siliciumsubstrat, beziehungsweise als diskreter Chipkondensator, vorzugsweise auf Siliciumsubstrat, wobei

auf ein entsprechend vorbereitetes Halbleitersubstrat (1), vorzugsweise Silicium, eine Hilfsschicht (2), vorzugsweise aus $SiO_2$, aufgebracht wird,

die Hilfsschicht (2) mit einer Reliefmaske (3) bedeckt wird, die aus einer dichtesten Anordnung stempelförmiger Elemente besteht,

diese Struktur der Reliefmaske (3) steilflankig in die Hilfsschicht (2) bis hinab zum Halbleiter substrat, übertragen wird, wodurch stempelförmige Elemente entstehen, von denen jedes zusammen mit dessen unmittelbarer Umgebung zur Erzeugung einer Elementarzelle der Kondensatorstruktur dient,

nach Entfernung der Reliefmaske (3), beginnend und endend mit der Abscheidung einer Lamellenschicht (4) in abwechselnder Folge eine Lamellenschicht (4), vorzugsweise aus Polysilicium, und danach eine Opferschicht (5), vorzugsweise aus $SiO_2$, abgeschieden werden,

wobei sich bei der Abscheidung der abschließenden Lamellenschicht (4), die das im Zentrum der Elementarzelle angeordnete, stempelförmige Element am weitesten außen umschließt, gemeinsame Berührungsflächen mit äußeren Lamellen (4) der benachbarten Elementarzellen ausbilden können,

mindestens nach jeder Abscheidung einer Opferschicht (5) ein anisotroper RIE-Ätzschritt angewendet wird, der die parallel zur Oberfläche des Halbleitersubstrats (1) angeordneten Bereiche der zuletzt abgeschiedenen Schicht bis auf die Oberfläche der darunterliegenden Schicht wieder entfernt, während die vertikalen Schichtbereiche im wesentlichen unverändert erhalten bleiben,

nach Abscheidung der abschließenden Lamellenschicht (4) die parallel zur Oberfläche des Halbleitersubstrates (1) angeordneten oberen Bereiche des aus Lamellenschichten (4) bestehenden Schichtstapels bis auf die Oberfläche der Hilfsschicht (2) bzw. die oberen Enden der vertikalen Bereiche der Opferschichten (5) entfernt werden,

anschließend die Hilfsschicht (2), sofern diese nicht schon nach Abscheidung der ersten Lamellenschicht (4) entfernt wurde, und die zwischen den vertikalen Teilen der Lamellenschichten (4) eingebetteten Opferschichten (5) mit einem isotropen naßchemischen Ätz- prozeß vollständig entfernt werden,

danach die aus Lamellenschichten (4) bestehende Reliefstruktur mit einer konformen Dielektrikumsschicht (9), vorzugsweise einer Oxid-Nitrid-Oxid-Isolatorschicht (ONO-Isolator), bedeckt wird,

anschließend eine leitfähige Deckelektrodenschicht (10), die die verbliebenen Zwischenräume zwischen den Lamellen (4) vollständig ausfüllt, vorzugsweise aus dotiertem Polysilicium, abgeschieden wird, und

nach der Strukturierung der Deckelektrodenschicht (10) ein Kontaktierungsprozeß ausgeführt wird.

2. Verfahren nach Anspruch 1, modifiziert für die Herstellung ein Trenchkondensatoranordnung aus einkristallinen Siliciumlamellen, wobei

als Material für die Lamellenschichten (4) ein gegenüber anisotroper RIE-Silicium-Ätzung und zugleich ge- genüber isotroper naß chemischer $SiO_2$-Ätzung ätzresistentes Schichtmaterial gewählt wird, vorzugsweise $Si_3N_4$,

nach der Entfernung der Hilfs- (2) und Opferschichten (5) mittels isotroper naßchemischer Ätzung alle noch verbliebenen horizontalen Bereiche der Lamellenschichten (4) bis auf die Oberfläche des Siliciumsubstrates (1) mit einem anisotropen, RIE-Ätzprozeß entfernt werden,

anschließend die Lamellenstruktur als Ätzmaske genutzt wird und mittels anisotroper selektiver RIE-Ätzung in das Siliciumsubstrat (1) übertragen wird, und

nach Reinigung und Entfernung der nach der Siliciumätzung noch verbliebenen Lamellenstruktur-Ätzmaskenreste die Kondensatoranordnung wie beschrieben komplettiert wird, beginnend mit der Aufbringung eines ONO-Isolators (9) bis zur Kontaktierung der Kondensatoranschlüsse.

## Claims

1. A process for manufacturing a capacitor arrangement with a high specific capacitance per area as an on-chip integrated capacitative element in integrated microelectronic circuits, preferably on a silicon substrate, or as a discrete chip capacitor, preferably on a Silicon substrate;

whereby an auxiliary layer (2), preferably of Silicon dioxid, is deposited on a prepared semiconductor substrate (1), preferably Silicon;

the auxiliary layer (2) is covered with a relief mask (3), which comprises a closely packed arrangement of cylindrical elements, each of which, together with its immediate surroundings, serves as the elementary cell for creating the capacitor structure;

the structure of the relief mask (3) is reproduced with sharp vertical contours in the auxiliary layer to the depth of the semiconductor substrate, creating regular cylindrical elements in the auxiliary material;

after removing the relief mask (3) alternate layers are deposited, a lamina layer (4), preferably of polysilicon, followed by a temporary layer (5), preferably of $SiO_2$, beginning and ending with the deposition of a lamina layer (4);

whereby the deposition of the final lamina layer (4), which extends furthest away from the centrally arranged cylindrical element of the elementary cell, can give rise to common regions with the outermost lamina of the neighbouring elementary cells;

at least after the deposition of each temporary layer (5), an anisotropic RIE-etching step is used, which removes the areas of the last deposited layer which are parallel to the surface of the semiconductor substrate (1) down to the surface of the layer below, while the vertical areas of the layer are preserved principally unchanged;

after depositon of the final lamina layer (4) the uppermost areas, consisting of a multilayer stack of lamina layers orientated parallel to the surface of the semiconductor substrate (1), are removed down to the surface of the auxiliary layer (2), or respectively, to the top ends of the vertical parts of the temporary layers (5);

next the auxiliary layer (2), if this has not already been removed after the deposition of the first lamina layer, and the temporary layers (5) embedded between the vertical parts of the lamina layers (4), are completely removed using an isotropic etching process;

after this the relief structure made from the lamina layers is covered with a standard dielectric layer (9), preferably an oxide-nitride-oxide-isolator layer (ONO-isolator);

next a conductive cover electrode (10) is deposited, which completely fills the spaces left between the laminates, preferably of doped polysilicon; and

following the configuration of the cover electrode layer (10) a contacting process is carried out.

2. Process according to claim 1, modified for the manufacture of a trench capacitor arrangement of crystalline silicon laminas; whereby

as material for the lamina layers (4), a layer material is chosen which is resistant to anisotropic silicon RIE-etching and at the same time to isotropic $SiO_2$ etching, preferably $Si_3N_4$ ;

after the removal of the auxiliary layer (2) and temporary layers ( 5) by isotropic etching all remaining horizontal areas of the lamina layers (4) are.removed with an anisotropic RIE etch process down to the surface of the silicon substrate (1);

next the lamina structure is used as an etching mask and is replicated in the silicon substrate (1) using a selective anisotropic RIE-etch, and

after cleaning and removal of the remains of the lamina structure etch mask left after the etching of the silicon the capacitor structure is completed as described, beginning with the coating with an ONO-isolator (9) up to the contacting of the capacitor connectors.

## Revendications

1. Procédé de l'arrangement de condensateur avec une grande capacité de couche spécifique comme élément capacitif intégré dans un chip ON dans les microcircuits intégrés, sur un substrat au silicium de préférence, ou bien comme condensateur de chip discret, sur un substrat au silicium de préférence, caractérisé par le fait

qu'une couche auxiliaire (2) en $SiO_2$ de préférence est mise sur un substrat semi-conducteur conformément préparé (1), au silicium de préférence,

que la couche auxiliaire (2) est couvert d'une masque à relief(3) qui se compose d'une disposition la plus compacte d'éléments en forme de tronc, dont chacun avec ses environs immédiats sert à générer une cellule élémentaire de la structure du condensateur,

que cette structure de la masque à relief (3) est transmise sous un angle aigu à la couche auxiliaire (2) jusqu'au bas du substrat semi-conducteur, ce qui produit des d'éléments en forme de tronc,

qu'après avoir enlevé la masque à relief (3), une couche lamellaire (4) au polysilicium de préférence, et ensuite une couche réactive (5) en $SiO_2$ de préférence sont séparées successivement, ce qui commence et finit par le dépôt d'une couche lamellaire (4),

qu'avec le dépôt de la couche lamellaire (4) de fermeture qui, à l'extérieur, entoure le plus largement l'élément en forme de tronc disposé au centre de la cellule élémentaire, il peut se former des surfaces de contact communes avec les lames (4) extérieures des cellules élémentaires contiguës,

qu'après chaque dépôt d'une couche réactive (5), on effectue au moins une étape de gravure RIE anisotrope qui enlève de nouveau les zones de la couche séparée à la fin, disposées parallèlement à la surface du substrat semi-conducteur (1), excepté la surface de la couche sous-jacente, tandis que les zones de couche verticales sont conservées dans un état à peu près inaltéré,

qu'après le dépôt de la couche lamellaire (4) de fermeture, on enlève les zones supérieures de l'empilage se composant des couches lamellaires (4), disposées parallèlement à la surface du substrat semi-conducteur (1), excepté la surface de la couche auxiliaire (2) ou bien les extrémités supérieures des zones verticales des couches réactives (5),

que l'on enlève complètement ensuite la couche auxiliaire (2), à moins que celle-ci ne soit déjà enlevée après le dépôt de la première couche lamellaire (4), et les couches réactives (5) enrobées entre les parties verticales des couches lamellaires (4) par un procédé de gravure isotrope par voie chimico-humide,

que la structure à relief qui se compose de couches lamellaires (4) est couverte ensuite d'une couche diélectrique (9) conforme, couche isolante à oxyde-nitrure-oxyde (isolateur ONO) de préférence,

qu'est séparée ensuite une couche d'électrode superficielle (10) conductrice au polysilicium dopé de préférence qui remplit complètement les interstices restés entre les lames (4), et

qu'après avoir structuré la couche d'électrode superficielle (10), on fait le bonding.

2. Procédé selon la revendication 1, modifié pour l'arrangement de condensateur Trench qui se compose de lames monocristallines, caractérisé par le fait

que l'on choisit, comme matière des couches lamellaires (4), une matière de couche en $Si_3N_4$ de préférence et à la fois résistante à la gravure du silicium RIE anisotrope et à la gravure du $SiO_2$ isotrope,

qu'après l'enlevage des couches auxiliaires (2) et des couches réactives (5), on enlève par un procédé de gravure RIE anisotrope toutes les zones horizontales encore restées des couches lamellaires (4), excepté la surface du substrat au silicium (1),

que la structure lamellaire est utilisée ensuite comme masque de gravure, étant transmise par la gravure RIE anisotrope sélective au substrat au silicium (1), et

qu'après le nettoyage et l'enlevage des restes de la masque de gravure dans la structure lamellaire qui sont encore restés après la gravure du silicium, l'arrangement de condensateur est complété, comme décrit, en commençant par la mise d'un isolateur ONO (9) jusqu'au bonding des connexions du condensateur.

FIG. 1

10
(DECKELEK-
TRODE)
GRUND-
ELEKTRODE

3
(RELIEFMASKE)

FIG 2 a
(SCHNITT C-D)

A

10

9

B

8

FIG 2 b
(SCHNITT A-B)

C

D

10

9

8

1

FIG 2 c
(SCHNITT A-B)

C

D

10

9

8

GRUND
ELEKTRODE

1

FIG.3 a-i (SCHNITT A-B)